Europäisches Patentamt

European Patent Office

Office européen des brevets

(11) Publication number: **0 406 526 A2**

# EUROPEAN PATENT APPLICATION

(21) Application number: 90106364.4

(22) Date of filing: 03.04.90

(51) Int. Cl.⁵: **H03K 17/28**, G04G 3/00

(30) Priority: 03.07.89 JP 171702/89

(43) Date of publication of application:
**09.01.91 Bulletin 91/02**

(84) Designated Contracting States:
**AT BE CH DE DK ES FR GB GR IT LI NL SE**

(71) Applicant: OMRON CORPORATION
10, Tsuchido-cho Hanazono Ukyo-ku
Kyoto 616(JP)

(72) Inventor: Yamamoto, Hiroyuki, c/o OMRON
CORPORATION
Intellectual Property Center, 20, Igadera
Shimokaiinji, Nagaokakyo-City, Kyoto 617(JP)
Inventor: Tomioka, Kiyotaka, c/o OMRON
CORPORATION
Intellectual Property Center, 20, Igadera
Shimokaiinji, Nagaokakyo-City, Kyoto 617(JP)

(74) Representative: WILHELMS, KILIAN &
PARTNER Patentanwältelte
Eduard-Schmid-Strasse 2
D-8000 München 90(DE)

(54) Timer with built-in batch counter.

(57) A timer with a batch counter comprises a counting unit for counting a number of time ups for a timer, an outputting unit for outputting a count up signal upon coincidence of a number counted by the counting unit with a predetermined number, a reset device for resetting the counting unit, and an input unit for inputting a count up number, wherein the time up number corresponds to a length of time it takes to perform a process and the count up number corresponds to a number of times the process is to be performed.

Xerox Copy Centre

## TIMER WITH BUILT-IN BATCH COUNTER

### BACKGROUND:

#### Field of the Invention:

This invention relates to a timer and more particularly to a timer with a batch counter which counts a number of time ups, the number of times a set value has been reached.

#### Related Art:

A related timer begins to operate on a given input and outputs a time up signal when it counts a predetermined time period. If the number of time up signals should be counted, then a counter is needed. For example, when a liquid pouring amount is controlled with a timer in a process where liquid is poured into a bottle, an external counter is used to count the number of time up signals in order to obtain the number of bottles which are filled with liquid. This is disadvantageous not only because the counter is cumbersome and takes up additional space, but also because it must be connected to the timer.

#### SUMMARY OF THE INVENTION:

An object of this invention is to provide a timer and batch counter utilizing a minimum of space.

Another object is to eliminate the need for connection workings necessary for connecting a timer with a batch counter.

Therefore, a timer with a built-in batch counter is provided, eliminating the need for connection workings and minimizing space needed to accommodate the apparatus.

Other objects and advantages of this invention will become apparent from the following description and accompanying drawings.

#### BRIEF DESCRIPTION OF THE DRAWINGS:

Fig. 1 is a block diagram of a timer with a built-in batch counter according to an embodiment of this invention.

Fig. 2 illustrates an embodiment of a panel for the timer with the built-in batch counter.

Fig. 3 is a flow chart illustrating an operation of the apparatus.

#### DESCRIPTION OF THE PREFERRED EMBODIMENTS:

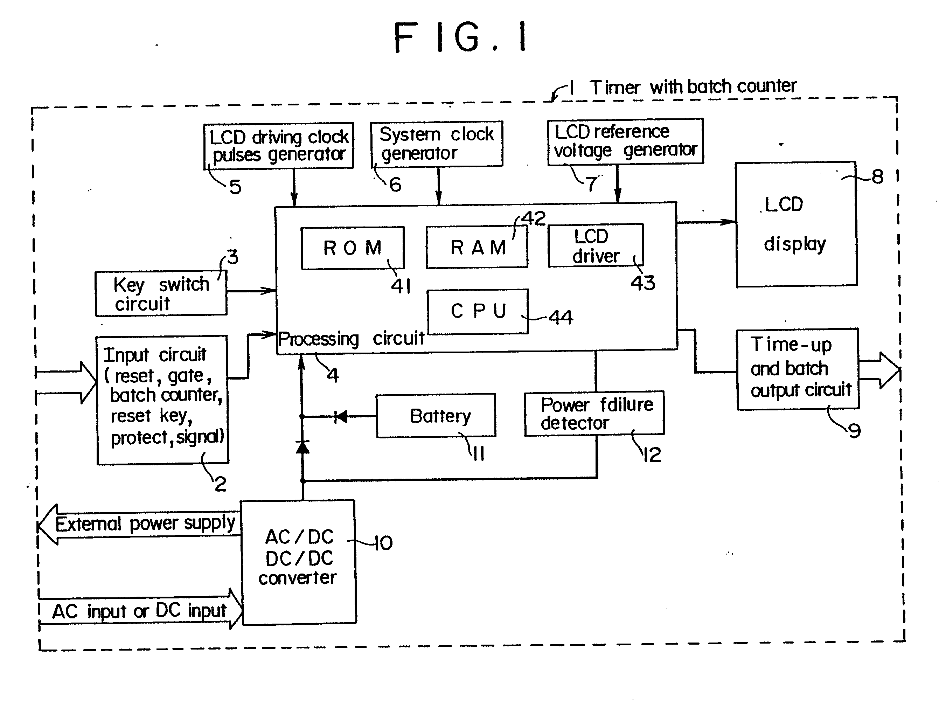

Fig. 1 illustrates the substantial composition of a timer with a batch counter 1 according to an embodiment of this invention. Control signals, such as: "reset" to reset timer, "gate" to stop timer, "batch count reset" to reset the batch counter, "key protect" to protect set values of shift keys from changing, and "signal" to signal the timer, are input through an input circuit 2. A key switch circuit 3 is used to enter limit values for the timer and the batch counter. A processing circuit 4 processes data and is comprised of a ROM 41, a RAM 42, an LCD driver 43, and a CPU 44. An LCD driving clock pulse generator 5 inputs low frequency clock pulses to the processing circuit 4 in the case of a power failure. The pulses emitted are of a low frequency and only enable the timer to perform a few vital functions because the pulse generator 5 is powered by a battery unit 11, the energy of which must be conserved. Usually, however, a system clock generator 6 inputs high frequency clock pulses to the processing circuit 4, enabling the circuit 4 to perform a variety of functions. Additionally, an LCD reference voltage generator 7 inputs voltage to the processing circuit 4. In turn, an LCD display 8 is controlled by the processing circuit 4. A time up and batch output circuit 9 is also controlled by the processing circuit 4.

The CPU 44 in the processing circuit 4 divides clock pulses outputted from the system clock generator 6. The CPU 44 then counts the divided pulses and compares the number of counted signals with a predetermined number which has been set by a key operation. When the number of divided clock pulses equals the predetermined number, a time up signal is outputted from the output circuit 9.

The processing circuit 4 is usually powered by an external AC or DC power supply via AC/DC, and DC/DC conversion circuit 10. However, if power is not supplied from an external AC or DC input through the conversion circuit 10, then power is supplied by the battery cell 11, which is a small, lightweight lithium battery. In the event of a power failure, a power failure detector 12 detects such a failure by comparing voltage output with a reference voltage. When the output voltage drops below the reference voltage, the failure detector 12 sends a signal to the processing circuit 4.

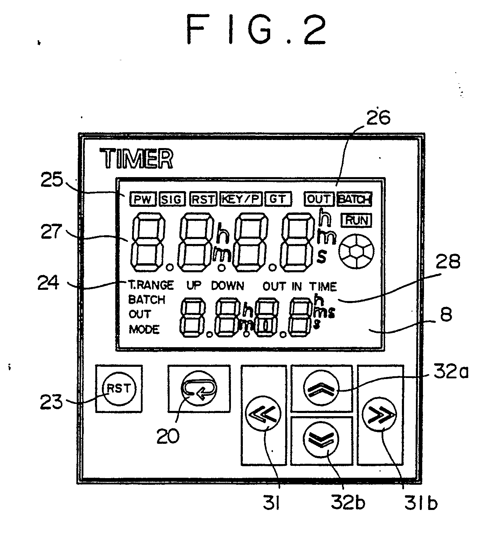

Fig. 2 is an illustration of a panel of the timer with a batch counter 1. As shown in Fig. 2, the panel partially includes the LCD display 8, a display switch key 20 , left shift key 31a, right shift key 31b, up shift key 32a, down shift key 32b, and a reset key **23**. These keys are used to set a predetermined number or to set operation modes. The display switch key **20** is used to change a display portion **27** to a time set display or a batch set display. Left and right shift keys **31** adjust a flickering cursor that indicates a number to be changed in a display portion **28**. The up and down shift keys **32** change the flickering number to a greater or lower value. By using these shift keys, which constitute the key switch circuit **3** in **Fig. 1**, desired time up values and batch count values can be set.

LCD display **8** further includes the mode display portion **24**, display portion **25** which indicates the control mode set by the input circuit **2**, control output display portion **26**, the number display portion **27** which displays the time in seconds for each time up progression, and display area **28** which displays a preset batch count number.

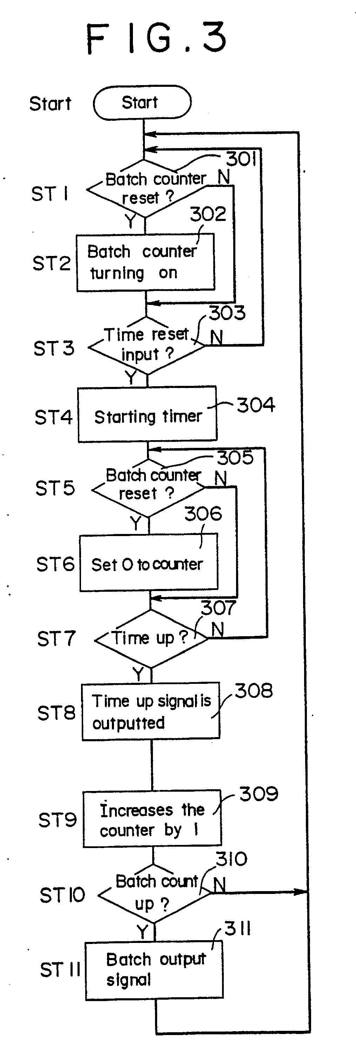

Turning now to an explanation of an operation of the apparatus as shown in the flow chart of **Fig. 3**, the CPU **44** determines whether a batch count reset signal is entered by a depression of the reset key **23** in **ST1**. If the reset key **23** has been pressed, then the flow chart moves to **ST2** and the batch counter is turned on. If, on the other hand, the CPU **44** determines that no reset signal is entered, the CPU then determines if a timer reset signal is entered in **ST3**. If a timer reset signal has not been entered either, then the operational flow goes back to the start and the CPU **44** waits for another signal which will trigger the routine again.

In the case where a timer reset signal has been entered, the timer is started in **ST4**. In **ST5** the CPU **44** again determines whether a batch count reset signal has been entered. If the determination is no, then the flow goes to **ST7**. If the CPU **44** determines that, yes, a batch count reset signal has been entered, then the batch counter is set to zero in **ST6**. In **ST7** the CPU determines whether a predetermined time up period has been reached. If the determination is yes, then a time up signal is outputted in **ST8**. If, on the other hand, the CPU **44** determines that a time up period has not been reached, then the flow returns to **ST5** and the CPU again determines whether a batch count reset signal has been entered and the operation is repeated as before.

Once the time up signal has been outputted from the output circuit **9** in **ST8** , the CPU **44** increases the number counted by the batch counter by one in **ST9**. In **ST10**, the CPU **44** checks if the batch counter has counted the predetermined number. If not, then the flow returns to **ST1**. But if the predetermined number has been counted, a batch count up signal is indicated by the control output display portion **26** in **ST11** and the program returns to **ST1** to begin again.

The above descriptions and accompanying drawings are merely illustrative of the applications of the principles of the present invention and are not limiting. Many other embodiments falling under the spirit and scope of this invention may be devised by those skilled in the art. Accordingly, this invention is only limited by the scope of the appended claims.

## Claims

1. A timer with a batch counter, comprising:
a counting means for counting a number of time ups for a timer;
an output means for outputting a count up signal upon coincidence of a number counted by said counting means with a predetermined number;
a reset means for resetting said counting means; and
an input means for inputting time up and count up numbers, wherein a time up corresponds to a length of time it takes to perform a process and a count up corresponds to a number of times a process is to be performed.

2. A timer with a batch counter according to claim 1, additionally comprising:
a power failure detecting means;
a power supply means;
a processing means; and
an auxiliary pulse generating means, wherein said auxiliary pulse generating means supplies power from said power supply means to said processing means when said power failure detecting means detects a power failure.

3. A timer with a batch counter according to claim 2, wherein said power supply means comprises a lithium battery.

4. A timer with a batch counter according to claim 1, additionally comprising a display means for displaying said time up and count up numbers.

5. A timer with a batch counter according to claim 4, wherein said display means comprises:
a number display portion; and
a preset number display area.

6. A timer with a batch counter according to claim 1, wherein said input means comprises:
a preset number display area;
a display switch key for changing said preset number display area to display a time up number or a count up number; and
shift keys for inputting desired time up and count up numbers.

FIG. 1

1 Timer with batch counter

- LCD display (8)
- Time-up and batch output circuit (9)
- LCD reference voltage generator (7)
- System clock generator (6)
- LCD driving clock pulses generator (5)
- Key switch circuit (3)
- Input circuit (reset, gate, batch counter, reset key, protect, signal) (2)

Processing circuit (4):
- ROM (41)
- RAM (42)
- LCD driver (43)
- CPU (44)

- Power failure detector (12)
- Battery (11)
- AC/DC DC/DC converter (10)

External power supply

AC input or DC input

# F I G . 2

# F I G . 3

Start — ( Start )

ST 1 — 301 Batch counter reset ? — N

ST2 — 302 Batch counter turning on

ST 3 — 303 Time reset input ? — N

ST4 — Starting timer — 304

ST 5 — 305 Batch counter reset ? — N

ST6 — 306 Set 0 to counter

ST 7 — 307 Time up ? — N

ST8 — Time up signal is outputted — 308

ST9 — Increases the counter by 1 — 309

ST 10 — 310 Batch count up ? — N

ST 11 — Batch output signal — 311